# EUROPÄISCHE PATENTSCHRIFT

(11) **EP 0 854 667 B1**
(45) Veröffentlichungstag und Bekanntmachung des Hinweises auf die Patenterteilung: **01.09.2004**
(21) Anmeldenummer: 98100677.8
(22) Anmeldetag: 16.01.1998
(51) Int. Cl.: H05K 5/00, H01R 12/18, H01R 12/20

(54) **Elektronisches Steuermodul**
Electronic control module
Module de commande électronique

(30) Priorität: 17.01.1997 DE 19701469
(43) Veröffentlichungstag der Anmeldung: 22.07.1998
(73) Patentinhaber: Conti Temic Microelectronic GmbH, 90411 Nürnberg (DE)
(72) Erfinder: Bäumel, Hermann, 92318 Neumarkt/Opf. (DE); Flierl, Werner, 92237 Sulzbach-Rosenberg (DE); Schuch, Bernhard, 91616 Neusitz (DE); Schüller, Ehrenfried, 90408 Nürnberg (DE); Zant, Udo, 90571 Schwaig (DE)

(56) Entgegenhaltungen:
- EP-A- 0 712 265
- EP-A- 0 731 539
- DE-A- 19 500 636
- US-A- 4 993 956

## Beschreibung

In vielen Anwendungsbereichen werden Eingangssignale (Meßwerte etc.) verarbeitende elektronische Steuermodule für unterschiedliche Aufgaben und Wirkungsweisen eingesetzt, insbesondere zur Steuerung von Prozeßabläufen; beispielsweise sind im Kraftfahrzeugbereich als elektronische Steuermodule mehrere die Meßsignale von Sensoren und die Ausgangssignale von Aktuatoren verarbeitende Steuergeräte zur Steuerung verschiedener Aggregatefunktionen des Kraftfahrzeugs (Motor, Getriebe etc.) vorgesehen. Elektronische Steuermodule bestehen üblicherweise aus einem Schaltungsträger (beispielsweise einer Leiterplatte), einer auf diesem Schaltungsträger angeordneten Schaltungsanordnung mit (bsp. durch Lötmontage oder Klebemontage aufgebrachten) Halbleiterbauelementen, aus einem die Schaltungsanordnung zum Schutz gegen Umwelteinflüsse umschließenden mechanisch stabilen Außengehäuse, in dem der Schaltungsträger befestigt ist, und aus einem mit (den Halbleiterbauelementen) der Schaltungsanordnung elektrisch leitend verbundenen Anschlußstecker, der im wesentlichen durch die Oberflächenbeschaffenheit des Schaltungsträgers vorgegeben ist, siehe z.B. EP-A-0 712 265 oder EP-A-0 731 539.
Oftmals werden elektronische Steuermodule großen Temperaturschwankungen ausgesetzt, was zu thermischen Belastungen führen kann (beispielsweise können die im Motorraum untergebrachten Steuergeräte eines Kraftfahrzeugs Temperaturen von -40 °C bis +150 °C ausgesetzt sein); darüberhinaus werden die elektronischen Steuermodule oftmals an Orten mit schädlichen oder aggressiven Umgebungsbedingungen eingesetzt. Die elektrische Kontaktierung zwischen dem Anschlußstecker und den Halbleiterbauelementen der Schaltungsanordnung wird daher entweder mittels temperaturbeständigen Lötverbindungen (insbesondere bei einer Lötmontage der Halbleiterbauelemente der Schaltungsanordnung auf dem Schaltungsträger) oder mittels temperaturbeständigen Bonddrahtverbindungen (insbesondere bei einer Klebemontage der Halbleiterbauelemente der Schaltungsanordnung auf dem Schaltungsträger, bsp. in Hybridtechnik) realisiert; weiterhin sind zusätzliche Dichtungen erforderlich, um die Schaltungsanordnung hermetisch zu verschließen.

Dieser standardmäßige Aufbau des elektronischen Steuermoduls bedingt folgende Nachteile:
- Schaltungsträger und Außengehäuse bzw. Schaltungsträger und Anschlußstecker sind fest miteinander verbunden und hierdurch nur sehr schwierig voneinander trennbar; falls eine Trennung vorgenommen wird (bsp. durch Auslöten), treten gravierende Schädigungen auf, so daß der Zustand des elektronischen Steuermoduls nach der Trennung nicht mehr dem Ausgangszustand vor der Montage entspricht (beispielsweise durch Beschädigungen der Bonddrähte oder der Oberfläche des Schaltungsträgers oder des Anschlußsteckers),
- durch den Anschlußstecker treten Dichtigkeitsprobleme auf, ggf. muß der Anschlußstecker zusätzlich abgedichtet werden,
- die Wiederverwertung bzw. Recyclingfähigkeit ist stark eingeschränkt,
- durch den aufwendigen Aufbau entstehen relativ hohe Kosten.

Der Erfindung liegt die Aufgabe zugrunde, ein elektronisches Steuermodul anzugeben, bei dem die genannten Nachteile vermieden werden und das vorteilhafte Eigenschaften aufweist, insbesondere einen einfachen Aufbau, eine einfache Kontaktierung von Anschlußstecker und Schaltungsanordnung, eine hohe Zuverlässigkeit, geringe Kosten und einen einfachen Herstellungsprozeß.
Diese Aufgabe wird gemäß der Erfindung durch die Merkmale des Patentanspruchs 1 gelöst.
Vorteilhafte Weiterbildungen der Erfindung ergeben sich aus den Unteransprüchen.

Das Außengehäuse des vorgestellten elektronischen Steuermoduls wird aus zwei zusammenfügbaren Gehäuseteilen gebildet: aus einem Trägerkörper als ersten, das Unterteil bzw. den "Boden" bildenden Gehäuseteil (bsp. eine metallische Gehäuseplatte), auf dem der Schaltungsträger mit den Schaltungskomponenten (bsp. Halbleiterbauelemente und/oder Sensoren) aufweisenden Schaltungsanordnung aufgebracht ist, und aus einem Gehäusekörper als zweiten, das Oberteil bzw. den "Deckel" bildenden Gehäuseteil (bsp. eine Kunststoffschale), in den ein Anschlußstecker mit mindestens einem Anschlußstekkerteil (mit einem oder mehreren Stanzgittern mit jeweils einer Vielzahl von Stanzgitteranschlüssen) und eine Dichtung integriert sind. Die Kontaktierung zwischen dem Anschlußstecker und den Schaltungskomponenten der Schaltungsanordnung erfolgt lötfrei beim Zusammenfügen der beiden Gehäuseteile mittels eines zwischen die beiden Gehäuseteile gelegten Kontaktierungsteils aus einer Vielzahl von auf einem Kontaktierungsträger angeordneten Kontaktgebern (bsp. mittels auf einer flexiblen Folie angeordneten Druckkontakten).

Die Schaltungsanordnung weist Kontaktstellen auf, die entweder durch die Anschlußkontakte der zu kontaktierenden Schaltungskomponenten (bsp. der Halbleiterbauelemente und/oder Sensoren) der Schaltungsanordnung selbst gebildet werden oder als von den Anschlußkontakten der zu kontaktierenden Schaltungskomponenten (bsp. mittels Leiterbahnen) weggeführte, auf der Oberfläche des Schaltungsträgers angeordnete Kontaktflecken ausgebildet sind (die Kontaktflecken sind insbesondere im Randbereich des Schaltungsträgers angeordnet und bsp. oberflächenmetallisiert, bsp. vergoldet); die Stanzgitteranschlüsse des Stanzgitters weisen an ihrem der Schaltungsanordnung zugewandten Ende jeweils ein Endstück auf, das als Halterung für den Kontaktierungsträger bzw. für die zugeordneten Kontaktgeber des Kontaktierungsteils dient. Vor dem Zusammenfügen der beiden Gehäuseteile wird das Kontaktierungsteil mit dem Kontaktierungsträger bzw. den Kontaktgebern auf die Endstücke der Stanzgitteranschlüsse aufgelegt, beim Zusammenfügen der beiden Gehäuseteile drücken die Kontaktgeber des Kontaktierungsteils auf die Kontaktstellen der Schaltungsanordnung (entweder auf die Anschlußkontakte der Schaltungskomponenten oder auf die Kontaktflecken des Schaltungsträgers) und stellen hierdurch die gewünschte elektrische Verbindung her sowie die Abdichtung des Gehäuses mittels der im Gehäusekörper integrierten Dichtung (die Verbindung zwischen den Kontaktgebern und den Kontaktstellen kann bsp. mittels Aufschnappen oder Verschraubung erfolgen).

Der Leiterbahnen aufweisende Schaltungsträger ist bsp. als starre oder (bsp. mittels Folien realisierte) flexible Leiterplatte oder als keramisches Substrat ausgebildet und plan auf dem Trägerkörper angeordnet; ggf. kann der Schaltungsträger auf dem Trägerkörper zusätzlich befestigt werden, bsp. mittels Verklebung oder Laminierung. Hierdurch wird zum einen eine sichere und zuverlässige Kontaktierung vermöge der Kontaktgeber des Kontaktierungsteils auf den Kontaktstellen der Schaltungsanordnung gewährleistet, zum andern kann hierdurch die Montage der Schaltungskomponenten der Schaltungsanordnung auf dem Schaltungsträger unabhängig von der Ausbildung des Anschlußsteckers erfolgen (d.h. die Schaltungskomponenten können bsp. auf den Schaltungsträger geklebt oder gelötet werden, ohne daß die Art der Montage Einfluß auf die konstruktive Anbindung des Anschlußsteckers hat).

Ist der Gehäusekörper als Kunststoffgehäusekörper ausgebildet, wird der integrierte Anschlußstecker (das/die Anschlußsteckerteil/e mit den Stanzgittern, den Stanzgitteranschlüssen und den Endstücken) und die bsp. als Gummidichtung ausgebildete Dichtung zum Trägerkörper hin in den Kunststoffgehäusekörper eingespritzt.

Die Ausgestaltung des Anschlußsteckers, d.h. die Anzahl der Anschlußsteckerteile, die Anzahl und Ausgestaltung der Stanzgitter (die Anzahl und Position der Stanzgitteranschlüsse des jeweiligen Stanzgitters), und die Ausgestaltung des Kontaktierungsteils (Anzahl und Position der Kontaktgeber) wird durch die Anzahl der zu kontaktierenden Schaltungskomponenten und deren zu kontaktierende Kontaktstellen bestimmt. Bei einer mehrlagigen Schaltungsanordnung mit in mehreren Ebenen übereinander angeordneten Schaltungsträgern können diese Schaltungsträger durch geeignete Ausbildung der (mehrreihigen) Stanzgitter bzw. Stanzgitteranschlüsse eines Anschlußsteckerteils oder mehrerer Anschlußsteckerteile durch einen Anschlußstecker gemeinsam kontaktiert werden; die Schaltungsträger der verschiedenen Ebenen können dabei unterschiedlich ausgebildet sein, bsp. aus unterschiedlichen Materialien bestehen.
Den Stanzgitteranschlüssen können beliebige Funktionen zugeordnet werden; bsp. können sie als Signalleitungen zur Weiterleitung von Ausgangssignalen/Eingangssignalen oder als Hochstromleitungen vorgesehen werden.

Das vorgestellte elektronische Steuermodul vereinigt mehrere Vorteile in sich:
- es ist ein kompakter Aufbau aus wenig Einzelteilen und eine einfache Kontaktierung von Anschlußstecker und Schaltungskomponenten gegeben,
- die Kontaktierung zwischen dem Anschlußstecker und den Schaltungskomponenten der Schaltungsanordnung erfolgt lötfrei und ist damit auf einfache Weise wieder lösbar, ist zuverlässig (es entsteht keine Reibung zwischen Schaltungsträger und Anschluß, da der Kontaktgeber nahezu massefrei ist und zudem kurze Signalwege realisierbar sind), und ermöglicht eine Vielzahl von (flexibel wählbaren) Verbindungen,
- es wird eine einfache, schnelle und kostengünstige Montage (Zusammenfügen der Einzelteile) bei gleichzeitiger Kontaktierung und Abdichtung sowie eine einfache, schnelle und kostengünstige Demontage (Auseinanderlösen der Einzelteile) des elektronischen Steuermoduls ermöglicht,
- durch den einfachen und beliebigen Austausch der Einzelteile (bsp. Austausch eines defekten Schaltungsträgers bei Wiederverwendung des Gehäusekörpers) ist das elektronische Steuermodul reparaturfreundlich, umweltfreundlich und recyclingfähig,
- der Gehäusekörper kann als kostengünstiges Kunststoffgehäuse ausgebildet werden und ist als Universalgehäuse unabhängig von der Technologie des Schaltungsträgers,
- das Außengehäuse gewährleistet durch die im Gehäusekörper integrierte Dichtung eine hohe Dichtigkeit, bsp. Dampfstrahlfestigkeit für den Einsatz im Kfz-Bereich,
- insgesamt erhält man somit ein flexibel handhabbares elektronisches Steuermodul mit einfachem Aufbau, hoher Zuverlässigkeit und geringen Kosten.

Das elektronische Steuermodul soll im folgenden für ein Ausführungsbeispiel, einem Steuergerät für die Motorsteuerung eines Nutzfahrzeugs anhand der Zeichnung mit den Figuren 1 bis 3 näher beschrieben werden.

Hierbei zeigt die Figur 1 zwei Draufsichten (Fig. 1a ohne Deckel, Fig. 1b mit Deckel), Figur 2 eine Seitenansicht des Steuergeräts und die Figur 3 eine Detailansicht der Verbindungsstelle zwischen Anschlußstecker und Schaltungsträger.

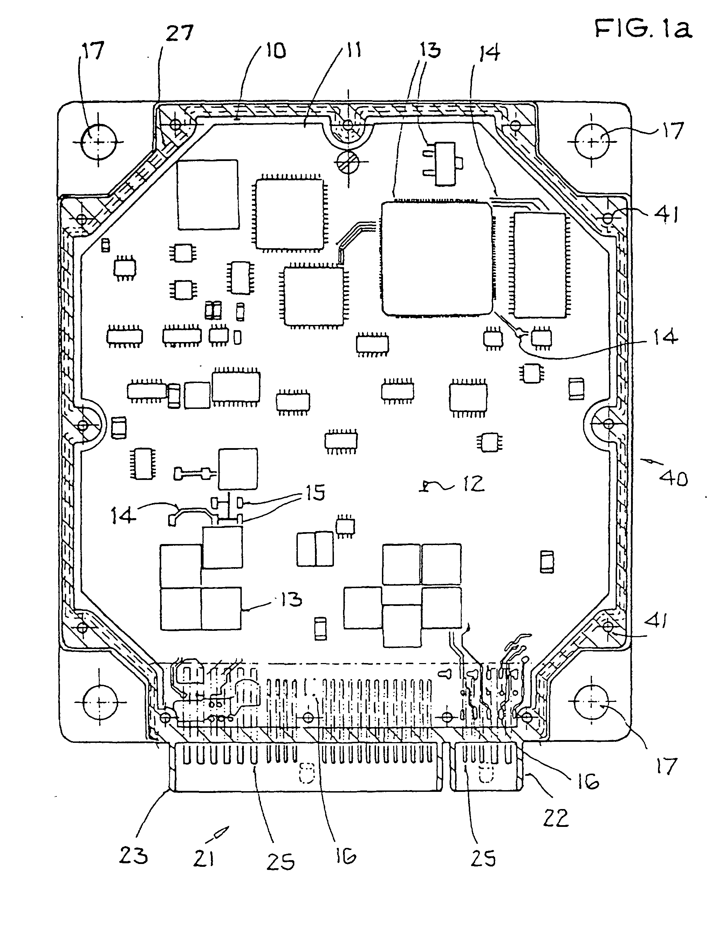

Gemäß der Draufsicht in den Fig. 1a und 1b wird das erste Gehäuseteil (der Boden) des Außengehäuses 40 des Steuergeräts durch den Trägerkörper 10 gebildet, der bsp. als Trägerplatte (bsp. ein oberflächenbehandeltes Aluminium-Stanzteil) mit den Maßen Länge x Breite x Höhe von 180 mm x 160 mm x 4 mm ausgebildet ist; der Trägerkörper 10 enthält vier Durchgangsöffnungen 17 (bsp. Bohrungen), die für die Befestigung des Steuergeräts bei der Montage am Einbauort dienen.

Gemäß der Fig. 1a ist auf den Trägerkörper 10 als Schaltungsträger 11 für die (nur schematisch explizit dargestellte) Schaltungsanordnung 12 eine flexible Leiterplatte (bsp. eine flexible Folie) vollflächig planar aufgebracht (bsp. mittels eines isolierenden und wärmeleitfähigen Klebers aufgeklebt). Auf den Schaltungsträger 11 sind die Schaltungskomponenten 13 der Schaltungsanordnung 12, Leiterbahnen 14 und als Kontaktstellen mit den zu kontaktierenden Anschlußkontakten 15 der Schaltungskomponenten 13 verbundene Kontaktflecken 16 angeordnet; die Oberfläche der Leiterbahnen 14 und die Kontaktflekken 16 ("Pads") sind oberflächenmetallisiert, bsp. mit einer Goldschicht überzogen.

Das in der Figur 1b dargestellte zweite Gehäuseteil (der Deckel) des Außengehäuses 40 des Steuergeräts wird durch den Gehäusekörper 20 gebildet, der bsp. als Kunststoffgehäusekörper (bsp. aus glasfaserverstärktem PBT) mit den Maßen Länge x Breite x Höhe von 180 mm x 160 mm x 25 mm ausgebildet ist.

Der Gehäusekörper 20 kann mit dem Trägerkörper 10 mechanisch fest verbunden werden, bsp. mittels der Schrauben 41 (siehe Fig. 1a) verschraubt werden. Im Gehäusekörper 20 ist der Anschlußstecker 21 mit zwei voneinander getrennten Anschlußsteckerteilen 22, 23 mit Stanzgitteranschlüssen 25 integriert (bsp. bei einem Kunststoffgehäusekörper eingespritzt). In den Gehäusekörper 20 ist weiterhin eine Dichtung 27 integriert, die bsp. als Silicon-Dichtung (diese kann bei einem Kunststoffgehäusekörper mit eingespritzt werden) oder als Dichtschnur ausgebildet ist; die Dichtung 27 dient zum hermetischen Verschließen des Außengehäuses 40 beim Zusammenfügen der beiden Gehäuseteile Trägerkörper 10 und Gehäusekörper 20.

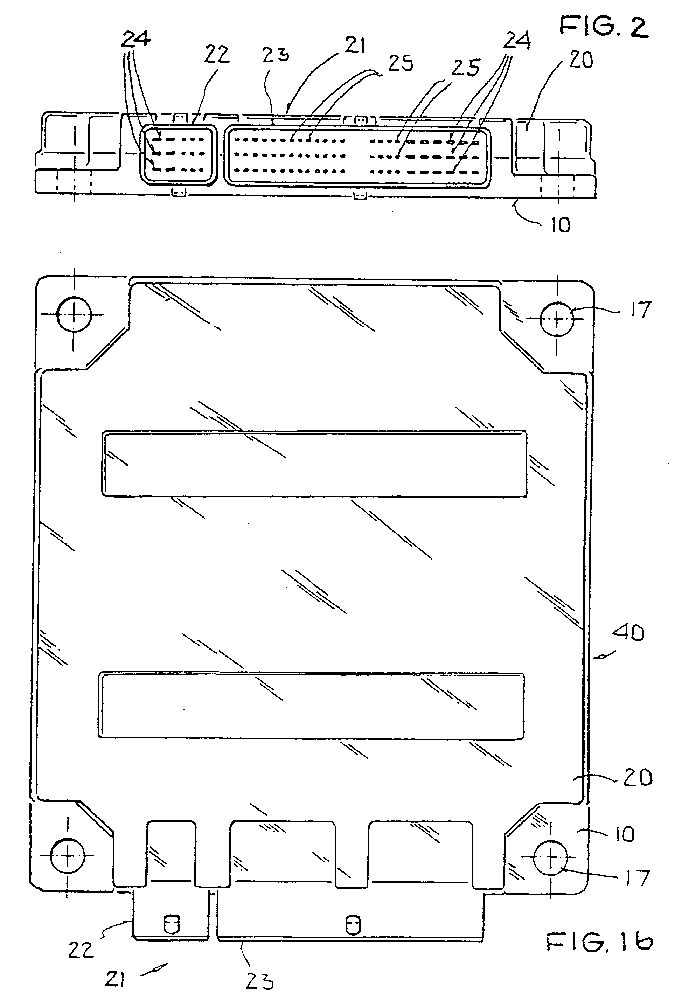

Die Figur 2 zeigt in einer Seitenansicht die beiden zusammengefügten Gehäuseteile Trägerkörper 10 und Gehäusekörper 20. Das hierdurch realisierte Steuergerät mit einer Gesamthöhe von bsp. 25 mm kann an der vorgesehenen Stelle im Kraftfahrzeug (bsp. am Ladeluftgehäuse) montiert werden. Die Anschlußsteckerteile 22, 23 des Anschlußstekkers 21 weisen jeweils drei übereinander angeordnete Stanzgitter 24 mit jeweils einer Vielzahl von Stanzgitteranschlüssen 25 auf (jede Reihe, d.h. jedes Stanzgitter 24 des dreireihigen ersten Anschlußsteckerteils 22 weist 5 Stanzgitteranschlüsse 25 auf, jede Reihe, d.h. jedes Stanzgitter 24 des dreireihigen zweiten Anschlußsteckerteils 23 weist 23 Stanzgitteranschlüsse 25 auf); jedes Anschlußsteckerteil 22, 23 kann ggf. mit einem separaten Außenstecker (dieser ist als Gegenstück des jeweiligen Anschlußsteckerteils 22, 23 ausgebildet) verbunden werden.

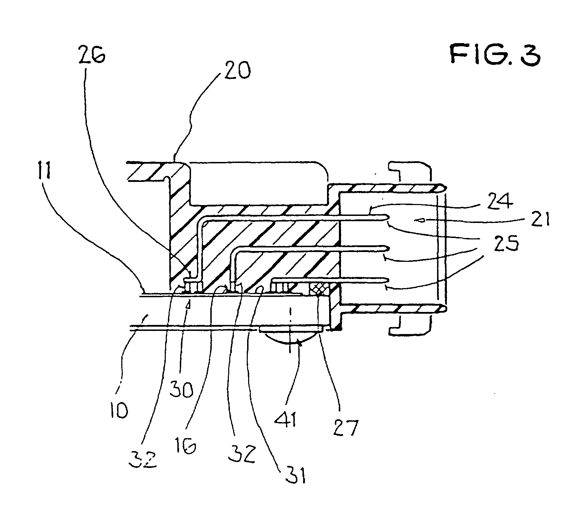

Gemäß der Figur 3 ist zur elektrischen Verbindung von Anschlußstecker 21 und Schaltungskomponenten 13 der Schaltungsanordnung 12 ein Kontaktierungsteil 30 mit einer Vielzahl von auf einem Kontaktierungsträger 31 (bsp. einer Schaltfolie) angeordneten, als Druckkontakte ("buttons") ausgebildeten Kontaktgebern 32 vorgesehen; die Druckkontakte 32 bestehen bsp. aus vergoldetem Molybdändraht mit einem Durchmesser von 0,5 mm für Signalkontakte und einem Durchmesser von 1 mm für Powerkontakte.

Die bsp. als Signalleitungen und Powerleitungen zur Weiterleitung von Eingangssignalen/Ausgangssignalen des Steuergeräts und zur Gewährleistung der Spannungsversorgung des Steuergeräts dienden Stanzgitteranschlüsse 25 der Anschlußsteckerteile 22, 23 bestehen bsp. aus Kupfer und weisen (bsp.vergoldete) Endstücke 26 als Kontakthalter für den Kontaktierungsträger 31 bzw. die Kontaktgeber 32 (Druckkontakte) des Kontaktierungsteils 30 auf. Beim Zusammenfügen der beiden Gehäuseteile Trägerkörper 10 und Gehäusekörper 20 drücken die Kontaktgeber 32 (Druckkontakte) gegen die auf dem Schaltungsträger 11 angeordneten Kontaktstellen (Kontaktflecken 16) und stellen hierdurch eine elektrische Verbindung zwischen den (Anschlußkontakten 15 der) Schaltungskomponenten 13 der Schaltungsanordnung 12 und den Stanzgitteranschlüssen 25 (und damit den Anschlußsteckerteilen 22, 23 bzw. dem Anschlußstecker 21) her.

## Patentansprüche

1. Elektronisches Steuermodul, mit
- einem Trägerkörper (10), auf den ein Schaltungsträger (11) zur Aufnahme einer Schaltungsanordnung (12) mit einer Vielzahl von zu kontaktierenden Schaltungskomponenten (13) planar aufgebracht ist,
- einem Gehäusekörper (20), in den mindestens ein Anschlußsteckerteil (22, 23) mit mindestens einem, eine Vielzahl von Stanzgitteranschlüssen (25) aufweisendes Stanzgitter (24) und eine Dichtung (27) integriert sind,
- einem Kontaktierungsteil (30) bestehend aus einer Vielzahl von auf einem Kontaktierungsträger(31) angeordneten Kontaktgebern (32),
wobei Trägerkörper (10) und Gehäusekörper (20) derart zusammenfügbar sind, daß
- ein abgedichtetes Außengehäuse (40) gebildet wird, und
- die auf den Stanzgitteranschlüssen (25) der Stanzgitter (24) aufliegenden Kontaktgeber (32) des Kontaktierungsteils (30) derart gegen auf der Schaltungsanordnung (12) vorgesehene Kontaktstellen (15; 16) drücken, daß das mindestens eine Anschlußsteckerteil (22, 23) mit den Schaltungskomponenten (13) der Schaltungsanordnung (12) elektrisch verbunden wird.

2. Elektronisches Steuermodul nach Anspruch 1, **dadurch gekennzeichnet, daß** die Stanzgitteranschlüsse (25) Endstücke (26) als Kontakthalter für die Kontaktgeber (32) des Kontaktierungsteils (30) aufweisen.

3. Elektronisches Steuermodul nach Anspruch 1 oder 2, **dadurch gekennzeichnet, daß** die auf der Schaltungsanordnung (12) vorgesehenen Kontaktstellen (15; 16) als Anschlußkontakte (15) der zu kontaktierenden Schaltungskomponenten (13) der Schaltungsanordnung (12) ausgebildet sind.

4. Elektronisches Steuermodul nach Anspruch 1 oder 2, **dadurch gekennzeichnet, daß** die auf der Schaltungsanordnung (12) vorgesehenen Kontaktstellen (15; 16) als von den Anschlußkontakten (15) der zu kontaktierenden Schaltungskomponenten (13) der Schaltungsanordnung (12) weggeführte, auf der Oberfläche des Schaltungsträgers (11) angeordnete Kontaktflecken (16) ausgebildet sind.

5. Elektronisches Steuermodul nach einem der Ansprüche 1 bis 4, **dadurch gekennzeichnet, daß** die Kontaktgeber (32) des Kontaktierungsteils (30) als Druckkontakte ausgebildet sind.

6. Elektronisches Steuermodul nach Anspruch 5, **dadurch gekennzeichnet, daß** die Druckkontakte (32) aus vergoldetem Molybdändraht gebildet sind.

7. Elektronisches Steuermodul nach einem der Ansprüche 1 bis 6, **dadurch gekennzeichnet, daß** der Kontaktierungsträger (31) des Kontaktierungsteils (30) als Schaltfolie ausgebildet ist.

8. Elektronisches Steuermodul nach einem der Ansprüche 1 bis 7, **dadurch gekennzeichnet, daß** der Schaltungsträger (11) als planare, flexible Folie ausgebildet ist.

9. Elektronisches Steuermodul nach einem der Ansprüche 1 bis 8, **dadurch gekennzeichnet, daß** der Trägerkörper (10) als metallische Trägerplatte ausgebildet ist.

10. Elektronisches Steuermodul nach Anspruch 9, **dadurch gekennzeichnet, daß** der Trägerkörper (10) aus Aluminium besteht.

11. Elektronisches Steuermodul nach einem der Ansprüche 1 bis 10, **dadurch gekennzeichnet, daß** der Gehäusekörper (20) aus Kunststoff besteht.

12. Elektronisches Steuermodul nach Anspruch 11, **dadurch gekennzeichnet, daß** das/die Anschlußsteckerteil/e (22, 23) aus Stanzgitter (24) und Stanzgitteranschlüssen (25) sowie die Dichtung (27) in den Kunststoff des Gehäusekörpers (20) eingespritzt sind.

## Claims

1. An electronic control module, comprising
- a carrier body (10), on which there is placed in planar manner a circuit carrier (11) for accommodating a circuit arrangement (12) including a plurality of circuit components (13) with which contact is to be made,
- a housing body (20), into which there are integrated a seal (27) and at least one terminal plug part (22, 23) including at least one punched grid (24) comprising a plurality of punched grid connectors (25),
- a contacting part (30) consisting of a plurality of contact makers (32) arranged on a contact carrier (31),
wherein the carrier body (10) and the housing body (20) are joinable in such a manner that
- a sealed external housing (40) is formed, and
- the contact makers (32) of the contacting part (30) resting upon the punched grid connectors (25) of the punched grids (24) press against contact points (15; 16) provided on the circuit arrangement (12) in such a manner that the at least one terminal plug part (22, 23) is electrically connected to the circuit components (13) of the circuit arrangement (12).

2. An electronic control module in accordance with Claim 1, **characterized in that** the punched grid connectors (25) comprise end pieces (26) serving as contact holders for the contact makers (32) of the contacting part (30).

3. An electronic control module in accordance with Claim 1 or 2, **characterized in that** the contact points (15; 16) provided on the circuit arrangement (12) are in the form of terminal contacts (15) for the circuit components (13) of the circuit arrangement (12) with which contact is to be made.

4. An electronic control module in accordance with Claim 1 or 2, **characterized in that** the contact points (15; 16) provided on the circuit arrangement (12) are in the form of contact areas (16) which are arranged on the surface of the circuit carrier (11) and are led away from the terminal contacts (15) of the circuit components (13) of the circuit arrangement (12) with which contact is to be made.

5. An electronic control module in accordance with any of the Claims 1 to 4, **characterized in that** the contact makers (32) of the contacting part (30) are in the form of pressure contacts.

6. An electronic control module in accordance with Claim 5, **characterized in that** the pressure contacts (32) are formed from gold-plated molybdenum wire.

7. An electronic control module in accordance with any of the Claims 1 to 6, **characterized in that** the contact carrier (31) of the contacting part (30) is in the form of a circuit foil.

8. An electronic control module in accordance with any of the Claims 1 to 7, **characterized in that** the circuit carrier (11) is in the form of a planar, flexible foil.

9. An electronic control.module in accordance with any of the Claims 1 to 8, **characterized in that** the carrier body (10) is in the form of a metallic mounting plate.

10. An electronic control module in accordance with Claim 9, **characterized in that** the carrier body (10) consists of aluminium.

11. An electronic control module in accordance with any of the Claims 1 to 10, **characterized in that** the housing body (20) consists of a synthetic material.

12. An electronic control module in accordance with Claim 11, **characterized in that** the terminal plug part/s (22, 23) comprising the punched grid (24) and the punched grid connectors (25) as well as the seal (27) are injected into the synthetic material of the housing body (20).

## Revendications

1. Module de commande électronique comportant
- un corps de support (10), sur lequel est monté à plat un support de circuit (11) servant à recevoir un montage (12) comportant une multiplicité de composants de circuit (13) avec lesquels un contact doit être établi,
- un corps de boîtier (20), dans lequel sont intégrées au moins une partie de connecteur de raccordement (22,23) comportant au moins une grille estampée (24) comportant une multiplicité de bornes (25), et une garniture d'étanchéité (27),
- une partie d'établissement de contact (30) constituée par une multiplicité d'éléments d'établissement de contact (32) disposés sur un support d'établissement de contact (31),
le corps de support (10) et le corps de boîtier (20) pouvant être réunis de sorte que
- un boîtier extérieur étanche (40) est formé, et
- les éléments d'établissement de contact (32) de la partie d'établissement de contact (30), qui s'appliquent sur les bornes (25) de la grille estampée (24), sont repoussés contre des emplacements de contact (15;16) prévus sur le montage (12) de telle sorte qu'au moins une partie de connecteur de raccordement (22,23) est reliée électriquement aux composants de circuit (13) du montage (12).

2. Module de commande électronique selon la revendication 1, **caractérisé en ce que** les bornes (25) de la grille estampée comportent des éléments d'extrémité (26) en tant que porte-contacts pour les éléments d'établissement de contact (32) de la partie d'établissement de contact (30).

3. Module de commande électronique selon la revendication 1 ou 2, **caractérisé en ce que** les emplacements de contact (15,16), qui sont prévus sur le montage (12), sont agencés sous 1a forme de contacts de raccordement (15) des composants de circuit (13), avec lesquels un contact doit être établi, du montage (12).

4. Module de commande électronique selon la revendication 1 ou 2, **caractérisé en ce que** les emplacements de contact (15,16), qui sont prévus sur le montage (12), sont agencés sous la forme de plages de contact (16), qui s'étendent à partir des contacts de raccordement (15) des composants de circuit (13), avec lesquels un contact doit être établi, du montage (12) et sont disposées sur la surface du support de circuit (11).

5. Module de commande électronique selon l'une des revendications 1 à 4, **caractérisé en ce que** les éléments d'établissement de contact (32) de la partie d'établissement de contact (30) sont agencés sous la forme de contacts à pression.

6. Module de commande électronique selon la revendication 5, **caractérisé en ce que** les contacts à pression (32) sont formés d'un fil de molybdène revêtu d'or.

7. Module de commande électronique selon l'une des revendications 1 à 6, **caractérisé en ce que** le support d'établissement de contact (31) de la partie d'établissement de contact (30) est agencé sous la forme d'une feuille de commutation.

8. Module de commande électronique selon l'une des revendications 1 à 7, **caractérisé en ce que** le support de circuit (11) est agencé sous la forme d'une feuille plane et flexible.

9. Module de commande électronique selon l'une des revendications 1 à 8, **caractérisé en ce que** le corps de support (10) est agencé sous la forme d'une plaque de support métallique.

10. Module de commande électronique selon la revendication 9, **caractérisé en ce que** le corps de support (10) est réalisé en aluminium.

11. Module de commande électronique selon l'une des revendications 1 à 10, **caractérisé en ce que** le corps (20) du boîtier est réalisé en une matière plastique.

12. Module de commande électronique selon la revendication 11, **caractérisé en ce que** la/les parties de connecteur de raccordement (22,23) constituées par la grille estampée (24) et les bornes (25) de cette grille ainsi que la garniture d'étanchéité (27) sont enrobées par injection dans la matière plastique du corps de boîtier (20).
